(19) Europäisches Patentamt / European Patent Office / Office européen des brevets

(11) **EP 4 697 042 A1**

(12) **EUROPEAN PATENT APPLICATION**
published in accordance with Art. 153(4) EPC

(43) Date of publication:
**18.02.2026 Bulletin 2026/08**

(21) Application number: **23937633.8**

(22) Date of filing: **30.10.2023**

(51) International Patent Classification (IPC):
**G01R 31/392** (2019.01)    **G01R 31/396** (2019.01)
**G01R 31/367** (2019.01)    **G01R 19/00** (2006.01)
**G01R 19/165** (2006.01)    **G01R 19/12** (2006.01)

(52) Cooperative Patent Classification (CPC):
Y02E 60/10

(86) International application number:
**PCT/KR2023/017024**

(87) International publication number:
**WO 2024/237403 (21.11.2024 Gazette 2024/47)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **17.05.2023 KR 20230063907**

(71) Applicant: **LG Energy Solution, Ltd.
Seoul 07335 (KR)**

(72) Inventors:
• **JANG, Jin Woo**
  **Daejeon 34122 (KR)**
• **KIM, Ki Hoon**
  **Daejeon 34122 (KR)**
• **JUNG, Jin Won**
  **Daejeon 34122 (KR)**

(74) Representative: **Plasseraud IP
104 Rue de Richelieu
CS92104
75080 Paris Cedex 02 (FR)**

(54) **BATTERY DIAGNOSTIC DEVICE, AND OPERATION METHOD THEREOF**

(57)    A battery diagnosis apparatus according to an embodiment disclosed herein includes an information obtaining unit configured to obtain time-series data regarding a voltage of each of a plurality of battery cells and a controller configured to calculate a moving average and a standard deviation for a reference unit from the time-series data of each battery cell and diagnose whether each battery cell is abnormal, based on the moving average and the standard deviation.

100

INFORMATION OBTAINING UNIT 110 — CONTROLLER 120

FIG.2

EP 4 697 042 A1

**Description**

**[Technical Field]**

CROSS-REFERENCE TO RELATED APPLICATION

This application claims priority to and the benefit of Korean Patent Application No. 10-2023-0063907 filed in the Korean Intellectual Property Office on May 17, 2023, the entire content of which is incorporated herein by reference.

TECHNICAL FIELD

Embodiments disclosed herein relate to a battery diagnosis apparatus and an operating method thereof.

**[Background Art]**

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

When a defect of a battery, such as short-circuit, negative electrode exposure, lithium precipitation, etc., occurs in a battery cell included in a battery pack, there is a risk of fire, making it necessary to early detect a defective battery cell and take action before occurrence of fire. Conventionally, an abnormal behavior of a voltage may occur in case of a defect such as short-circuit, negative electrode exposure, etc., in a battery cell, and thus may be detected in the unit of a battery pack and diagnosed. However, there is a need for a diagnosis method capable of detecting an abnormal behavior of a voltage in the unit of an individual cell.

**[Disclosure]**

**[Technical Problem]**

Embodiments disclosed herein aim to provide a battery diagnosis apparatus and an operating method thereof in which abnormality may be diagnosed in the unit of an individual battery cell of a battery pack.

Embodiments disclosed herein aim to provide a battery diagnosis apparatus and an operating method thereof in which a battery cell may be accurately diagnosed by masking a value of a specific period when the battery cell is diagnosed.

Technical problems of the embodiments disclosed herein are not limited to the above-described technical problems, and other unmentioned technical problems would be clearly understood by one of ordinary skill in the art from the following description.

**[Technical Solution]**

A battery diagnosis apparatus according to an embodiment disclosed herein includes an information obtaining unit configured to obtain time-series data regarding a voltage of each of a plurality of battery cells and a controller configured to calculate a moving average and a standard deviation for a reference unit from the time-series data of each battery cell and diagnose whether each battery cell is abnormal, based on the moving average and the standard deviation.

According to an embodiment, the controller may be further configured to normalize a voltage value at a current point in time for each battery cell with a moving average and a standard deviation at a previous point in time, and calculate an error rate based on the voltage value normalized for each battery cell.

According to an embodiment, the controller may be further configured to calculate the error rate by applying an error function (erf) to the normalized voltage value.

According to an embodiment, the controller may be further configured to determine a battery cell having the error rate, an absolute value of which exceeds a first value, as defective.

According to an embodiment, the first value may be set to 0.65.

According to an embodiment, the controller may be further configured to mask the error rate with 0 for a period of the time-series data in which a change rate of current is greater than a threshold degree.

According to an embodiment, the controller may be further configured to calculate a deviation of the error rate of each battery cell and determine a battery cell having the deviation, an absolute value of which exceeds a second value, as defective.

According to an embodiment, the second value may be set to 0.25.

A battery diagnosis method according to an embodiment disclosed herein includes obtaining time-series data regarding a voltage of each of a plurality of battery cells, calculating a moving average and a standard deviation for a reference unit from the time-series data of each battery cell, and diagnosing whether each battery cell is abnormal, based on the moving average and the standard deviation.

According to an embodiment, the diagnosing of whether each battery cell is abnormal may include normalizing a voltage value at a current point in time for each battery cell with a moving average and a standard deviation at a previous point in time and calculating an error rate based on the voltage value normalized for each battery cell.

According to an embodiment, the diagnosing of whether each battery cell is abnormal may further include determining a battery cell having the error rate, an absolute value of which exceeds a first value, as defective.

According to an embodiment, the calculating of the error rate may include calculating the error rate by applying an error function (erf) to the normalized voltage value.

According to an embodiment, the calculating of the error rate may include masking the error rate with 0 for a period of the time-series data in which a change rate of current is greater than a threshold degree.

According to an embodiment, the diagnosing of whether each battery cell is abnormal may further include calculating a deviation of the error rate of each battery cell and determining a battery cell having the deviation, an absolute value of which exceeds a second value, as defective.

**[Advantageous Effects]**

The battery diagnosis apparatus and the operating method thereof according to an embodiment disclosed herein may diagnose abnormality in the unit of an individual battery cell.

The battery diagnosis apparatus and the operating method thereof according to an embodiment disclosed herein may perform both diagnosis in the unit of an individual battery cell and diagnosis in the unit of a battery pack, thereby improving accuracy and efficiency of diagnosis.

Moreover, various effects recognized directly or indirectly from the disclosure may be provided.

**[Description of Drawings]**

FIG. 1 is a block diagram showing a configuration of a general battery pack.

FIG. 2 is a block diagram of a battery diagnosis apparatus according to an embodiment disclosed herein.

FIG. 3A shows an example of time-series data regarding a voltage of each of a plurality of battery cells.

FIGS. 3B to 3D show an example of an error rate calculated for a battery cell.

FIG. 4 shows an example of an error rate deviation of battery cells.

FIG. 5 is a flowchart of a battery diagnosis method according to an embodiment disclosed herein.

FIG. 6 is a flowchart illustrating in detail a battery diagnosis process according to an embodiment disclosed herein.

FIG. 7 is a block diagram showing a hardware configuration of a computing system for performing an operating method of a battery management apparatus, according to an embodiment disclosed herein.

**[Mode for Invention]**

Hereinafter, various embodiments of the present disclosure will be disclosed with reference to the accompanying drawings. However, the description is not intended to limit the present disclosure to particular embodiments, and it should be construed as including various modifications, equivalents, and/or alternatives according to the embodiments of the present disclosure.

Herein, it is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

Each component (e.g., a module or a program) of the components described herein may include a single entity or multiple entities. According to various embodiments, one or more of the components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

As used herein, the term "module" or "unit" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments of the present document may be implemented as software (e.g., a program or application) including one or more instructions that are stored in a storage medium (e.g., a memory) that is readable by a machine. For example, a processor of the machine may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

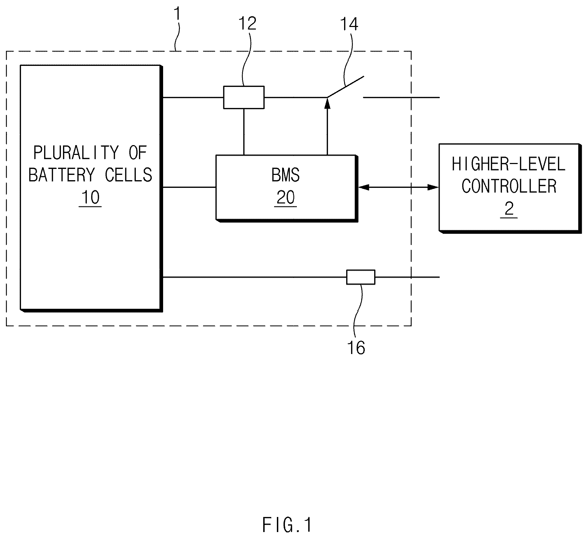

FIG. 1 is a block diagram showing a configuration of a general battery pack.

Referring to FIG. 1, a battery control system including a battery pack 1 and a higher-level controller 2 included in a higher-level system according to an embodiment of the present disclosure is schematically shown.

As shown in FIG. 1, the battery pack 1 may include a plurality of battery cells 10 that include one or more battery cells and are chargeable/dischargeable, a switching unit 14 serially connected to positive (+) terminal sides or negative (-) terminal sides of the plurality of battery cells 10 to control a charging/discharging current flow of the plurality of battery cells 10, and a battery management system 20 for control and management to prevent over-charging and over-discharging by monitoring voltage, current, temperature, etc., of the battery pack 1. The battery pack 1 may include the plurality of battery cells 10, the sensor 12, the switching unit 14, and the battery management system 20 provided in plural.

Herein, as the switching unit 14 which is an element for controlling a current flow for charging or discharging of the plurality of battery cells 10, for example, at least one relay, magnetic contactor, etc., may be used according to specifications of the battery pack 1.

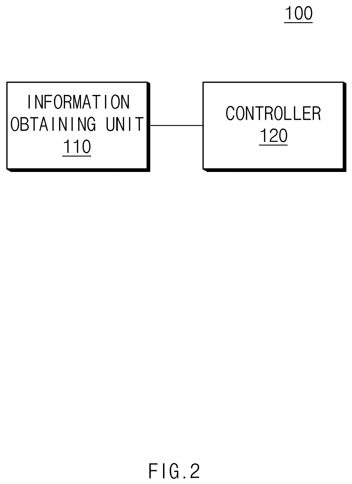

The battery management system 20, which is an interface for receiving measurement values of the above-described various parameter values, may include a plurality of terminals and a circuit, etc., connected thereto to process input values. The battery management system 20 may control on/off of the switching unit 14, e.g., a relay, a contactor, etc., and may be connected to the plurality of battery cells 10 to monitor the state of each battery cell 10. According to an embodiment, the battery management system 20 may include a battery management apparatus 100 of FIG. 2. According to another embodiment, the battery management system 20 may be different from the battery management apparatus 100 of FIG. 2. That is, the battery management apparatus 100 of FIG. 2 may be included in the battery pack 1 and may be configured as another device outside the battery pack 1. The following operation of the battery management apparatus 100 may also be performed in various devices such as not only a battery management system (BMS) in a vehicle, but also a server, a cloud, a charger, a charger/discharger, etc.

The higher-level controller 2 may transmit a control signal regarding the plurality of battery cells 10 to the battery management system 20. Thus, the battery management system 20 may also be controlled in terms of an operation thereof based on a signal applied from the higher-level controller 2.

FIG. 2 is a block diagram of a battery diagnosis apparatus according to an embodiment disclosed herein.

Referring to FIG. 2, the battery diagnosis apparatus 100 according to an embodiment disclosed herein may include an information obtaining unit 110 and a controller 120. Depending on an embodiment, the battery diagnosis apparatus 100 may be included in the battery management system 20 of FIG. 1 or may be another device that is different from the battery management system 20 of FIG. 1.

The battery diagnosis apparatus 100 may analyze time-series data regarding a voltage of each of the plurality of battery cells included in the battery pack 1 to diagnose voltage abnormality in the unit of an individual battery cell. The battery diagnosis apparatus 100 may diagnose whether a battery cell is abnormal, by determining abnormality of a voltage behavior of each battery cell.

The information obtaining unit 110 may obtain time-series data regarding a voltage of each of the plurality of battery cells. For example, the information obtaining unit 110 may obtain the time-series data by obtaining a voltage value at time intervals determined for each battery cell. For example, the information obtaining unit 100 may obtain time-series data $(v_1, v_2, ..., v_m)$ regarding m voltage values, obtained at m points in time, by obtaining a voltage of each battery cell at determined time intervals. The information obtaining unit 110 may further obtain cell-related data such as current, temperature, etc., in addition to voltage of each battery cell.

The controller 120 may calculate a moving average and a standard deviation for a reference unit from the time-series data of each battery cell. The moving average may mean an average calculated while moving a subset having a specific size in the time-series data, and the size of the subset may mean the number of pieces of data belonging to the subset. For example, when the size of the subset is 5, the controller 120 may calculate the moving average for five adjacent pieces of data in time-series data of each battery cell. A moving average calculated at a point t in time may mean an average value from voltage data at a point (t-4) in time to voltage data $(v_{t-4} \sim v_t)$ at the point t in time.

The reference unit may be a unit indicating the size of the subset for calculating the moving average in the time-series data. For example, when the size of the subset used for moving average calculation is 5, the reference unit may be 5. In another example, when the size of the subset is 5 and the time-series data is obtained at a time interval of 1 second, then the reference unit may be 5 seconds. Likewise, the controller 120 may calculate the standard deviation for the reference unit.

For example, when time-series data for a voltage of a specific cell obtained by the information obtaining unit 110 is $(v_1, v_2, ..., v_m)$, then the controller 120 may calculate time-series data for the moving average and time-series data for the standard deviation therefrom, and for the reference unit of 5, the calculated moving average and standard deviation may be expressed as $(mean_5, mean_6, ..., mean_m)$ and $(std_5, std_6, ..., std_m)$, respectively.

In this case, the moving average and the standard deviation may satisfy equations below.

[Equation 1]

$$ mean_t = mean_{t-1} + \frac{v_t - mean_{t-1}}{n} $$

[Equation 2]

$$ std_t = std_{t-1} + \frac{(v_t - mean_{t-1})^2}{n} - \frac{std_{t-1}}{n-1} $$

Herein, $mean_t$ and $std_t$ may mean the moving average and the standard deviation at the point t in time, respectively, $v_t$ may mean a time-series data term of a voltage at the point t in time, and n may mean a reference unit. Thus, the controller 120 may calculate the moving average and the standard deviation and examine distribution, change, and behavior of the moving average and the standard deviation, thereby identifying a trend of voltage distribution of each battery cell.

The controller 120 may diagnose whether each battery cell is abnormal, based on the moving average and the standard deviation. For example, when a change of a moving average or a standard deviation of a specific cell at a certain point in time exceeds a threshold value, the controller 120 may determine that the cell is defective or determine that more detailed analysis is required. In another example, the controller 120 may calculate a parameter (e.g., an error rate described below) for cell diagnosis from the moving average and the standard deviation and diagnose whether the cell is abnormal, based on the calculated parameter.

According to an embodiment, the controller 120 may normalize a voltage value at a current point in time for each battery cell with a moving average and a standard deviation at a previous point in time. The controller 120 may normalize a voltage value of each term of time-series data with the moving average and the standard deviation calculated at the previous point in time, thereby calculating the normalized voltage value. For example, the normalized voltage value may be expressed as $norm_t = \frac{v_t - mean_{t-1}}{std_{t-1}}$. The controller 120 may normalize each term of time-series data, thereby identifying distribution of a voltage behavior by applying characteristics of a voltage behavior (a moving average and a standard deviation) at the previous point in time to data of each term.

According to an embodiment, the controller 120 may calculate an error rate based on the normalized voltage value for each battery cell. The controller 120 may calculate the error rate based on the normalized voltage value, thereby quantifying and identifying the extent to which the voltage behavior of the cell deviates from normal distribution. The controller 120 may normalize a voltage value of each term and calculate an error rate, thereby more clearly identifying whether the cell is abnormal and improving the accuracy of diagnosis, when compared to simple voltage value comparison.

According to an embodiment, the controller 120 may calculate an error rate by applying an error function to the normalized voltage value. In an embodiment, the error function may be expressed as

$$erf(x) = \frac{2}{\sqrt{\pi}} \int_0^x e^{-t^2} dt$$

, and the error rate may be expressed as $diag_t = erf(norm_t)$. In this case, the error rate may have a range of [-1, 1], in which the closer the error rate is to 0, the closer it is to the existing distribution and the closer the error rate is -1 or 1, the farther it is from the existing distribution. This is just an example, and the controller 120 may calculate the error rate to have a different distribution and apply an error function different from the foregoing example.

According to an embodiment, the controller 120 may determine that a battery cell having an error rate, an absolute value of which exceeds a first value, is defective. The controller 120 may determine that the cell is defective by determining that abnormality occurs in the cell, because the greater absolute value of the error rate may mean that the voltage behavior of the cell deviates significantly from the existing distribution. For example, the controller 120 may determine that a specific battery cell is defective when an absolute value of an error rate exceeds the first value at any one point in time. In another example, the controller 120 may determine that a battery cell is defective when the absolute value of the error rate of the specific ell exceeds the first value a preset number of times or more.

The first value may be statistically and experimentally set, and may be set to a value for apparently distinguishing a normal behavior of a battery cell voltage from an abnormal behavior of the battery cell voltage. For example, the first value may be set greater than a maximum error rate that may generally occur in the normal behavior of the battery cell voltage. For example, the first value may be set to 0.65.

As such, the controller 120 may analyze the voltage behavior of each battery cell, thereby separately diagnosing whether the cell is abnormal. The controller 120 may separately analyze each battery cell to diagnose whether the battery cell is abnormal, and analyze relativity of each battery cell in the battery pack to diagnose whether the battery cell is abnormal.

According to an embodiment, the controller 120 may calculate an error rate deviation of each battery cell. For example, the controller 120 may calculate an average of error rates of each battery cell at the same point in time and calculate an error rate deviation from a difference between the error rate of and the average of each battery cell.

According to an embodiment, the controller 120 may determine that a battery cell having an error rate deviation, an absolute value of which exceeds a second value, is defective. When a deviation of a specific battery cell is large in the same environment, the battery cell has a behavior different from other battery cells, such that the controller 120 may determine that the battery cell is defective.

The second value may be statistically and experimentally set, and for example, the second value may be set greater than a relative deviation that may generally occur in the normal behavior of the battery cell voltage. For example, the second value may be set to 0.25.

As such, the controller 120 may diagnose whether each cell is abnormal, by relatively analyzing battery cells in the battery pack 1. For example, when the voltage behaviors of the battery cells significantly deviate from the previous behavior distribution, but all the cells have the same voltage behavior, then it may be inappropriate to determine only a specific cell as defective. Also in this case, the controller 120 may relatively compare the battery cells to diagnose whether the battery cells are abnormal.

According to an embodiment, the controller 120 may determine that the battery pack 1 is defective or needs precise diagnosis, when battery cells determined as defective exceed a preset number or a preset rate. For example, when those determined as defective exceed a preset rate of total battery cells included in the battery pack 1 as a result of diagnosing each battery cell, the controller 120 may determine that the battery pack 1 is a precise diagnosis target.

When the battery cell is identified as defective as a result of diagnosis, the controller 120 may provide information about an abnormal battery cell to a user. For example, the controller 120 may provide information about a defective battery cell to a user terminal through a communication unit (not shown) and provide the information about the defective battery cell through a display provided in a vehicle, a charger, etc.

According to an embodiment, the controller 120 may mask an error rate with 0 for a period of time-series data in which a change rate of current is greater than a threshold degree. That is, the controller 120 may perform masking by replacing an error rate calculated in a period corresponding to a large current change of each battery cell with 0. The current of each battery cell may be obtained from the information obtaining unit 110. For example, when the change rate of the current of the battery cell is greater than the threshold degree at a point in time when the time-series is obtained, then the controller 120 may mask an error rate calculated at that point in time with 0. For example, in a charging/discharging period of the battery cell, the voltage change of the battery cell may be large due to the sharp change of the charging/discharging current. However, the large change of the battery cell voltage occurring in this case may corresponding to the normal behavior rather than the abnormal behavior, and thus may need to be distinguished from the abnormal behavior corresponding to the actual defect. Thus, the controller 120 may mask the error rate with 0 in a period where the change rate of the current of the battery cell is greater than the threshold degree, so as to prevent the battery cell from being determined as defective even when the voltage behavior of the battery cell is normal. To this end, the battery diagnosis apparatus 100 may prevent the normal behavior from being misdiagnosed as the abnormal behavior in a charging/-discharging period, etc.

In another embodiment, the controller 120 may perform diagnosis of a battery cell in a period where the change rate of the current of the battery cell is less than or equal to a predetermined level. For example, the controller 120 may perform diagnosis of the battery cell in a period of $\Delta I < 2mV$, and for example, the controller 120 may perform a diagnosis procedure in an idle period of the battery pack 1. As described above, the controller 120 may perform a diagnosis procedure in a period where a voltage behavior is stable due to a low change rate of the current, such as in the idle period, etc., to prevent a sharp voltage change in some periods, occurring according to a charging/discharging pattern, etc., from being misdiagnosed as the abnormal behavior even when the voltage behavior of the battery cell is normal.

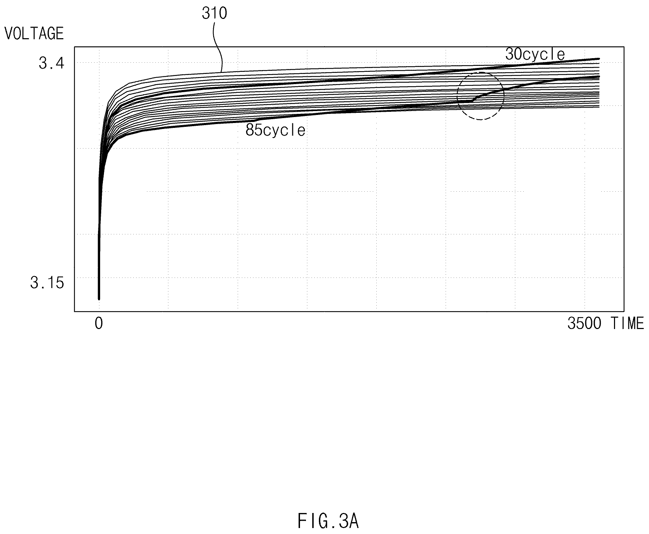

FIG. 3A shows an example of time-series data regarding a voltage of each of a plurality of battery cells.

Referring to FIG. 3A, a graph 310 of time-series data regarding a voltage of each battery cell is shown. In the graph 310, each line may indicate a graph for time-series data of each battery cell. The battery diagnosis apparatus 100 may aim to detect abnormality of the voltage behavior occurring in a specific battery cell, for example, as in a part indicated by a circle of FIG. 3A.

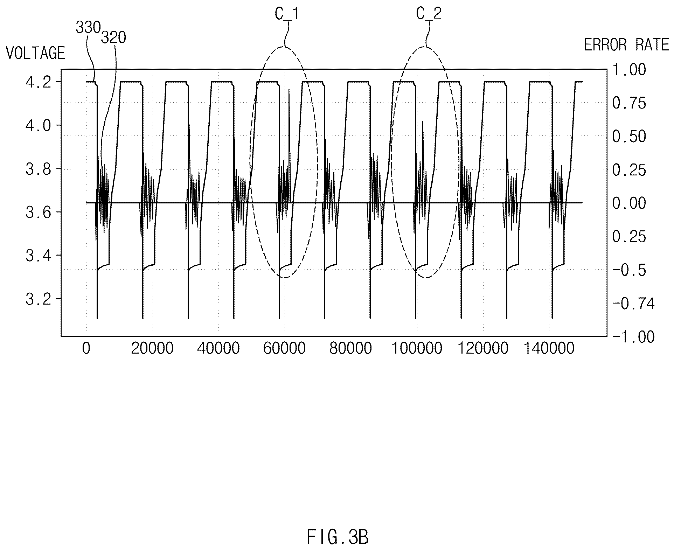

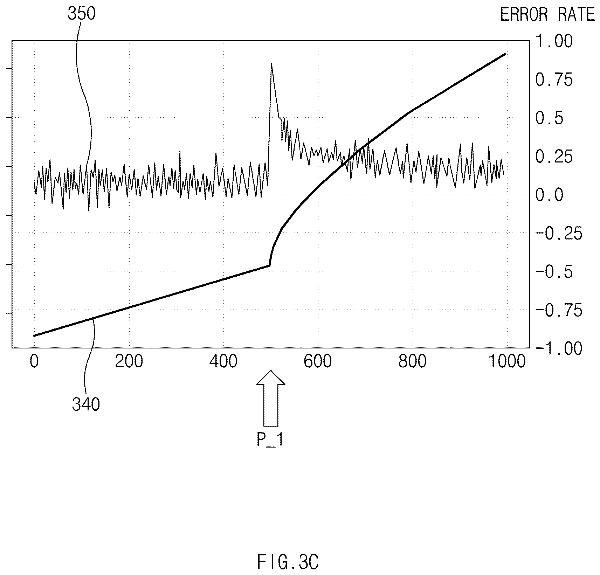

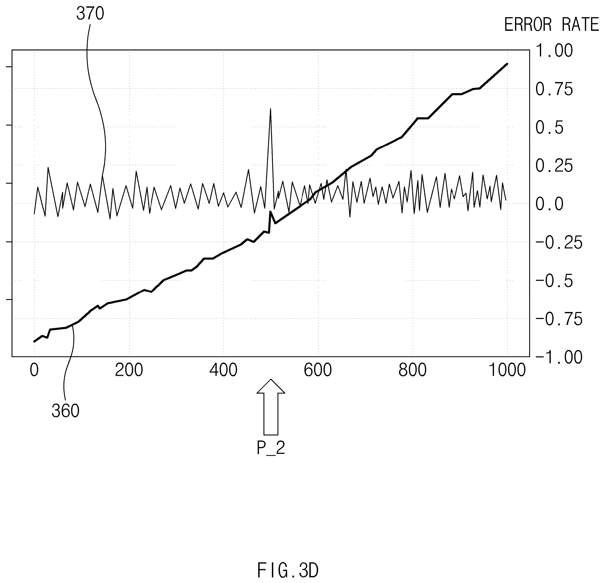

FIGS. 3B to 3D show an example of an error rate calculated for a battery cell. More specifically, FIGS. 3C and 3D enlarge and express periods C_1 and C_2 of FIG. 3B, respectively.

Referring to FIG. 3B, a graph 320 regarding an error rate of a specific battery cell and a graph 330 regarding a voltage are shown. In FIG. 3B, an x-axis example indicates a time, a left y-axis example indicates a voltage, and a right y-axis example indicates an error rate. The battery diagnosis apparatus 100 may determine abnormality of a battery cell based on an absolute value of an error rate calculated for the battery cell. For example, the battery diagnosis apparatus 100 may detect a point at which the absolute value of the error rate of the battery cell exceeds the first value.

The controller 120 may mask an error rate with 0 in a period in which the change rate of the current of the battery cell is greater than the threshold degree. It may be seen from the graph 330 regarding the voltage in FIG. 3B that in the charging/discharging period in which the voltage changes rapidly (the voltage behavior is normal but the voltage change rate is also high as the current change rate is high), the error rate is processed as 0 in the graph 320 regarding the error rate.

FIGS. 3C and 3D enlarge and express periods C_1 and C_2 of FIG. 3B, respectively. A graph 350 regarding the error rate of FIG. 3C and a graph 370 regarding the error rate of FIG. 3D are parts of the graph 320 regarding the error rate of FIG. 3B. A graph 340 regarding the voltage of FIG. 3C and a graph 360 regarding the error rate of FIG. 3D are parts of the graph 330 regarding the error rate of FIG. 3B. In FIGS. 3C and 3D, an x-axis indicates a relative time with respect to 0 as a start point of each of the periods C_1 and C_2. The battery diagnosis apparatus 100 may detect a point P_1 of FIG. 3C and a point P_2 of FIG. 3D at which the absolute value of the error rate is greater than or equal to the threshold value. In this case, the threshold value may be set between, for example, 0.4 and 0.65.

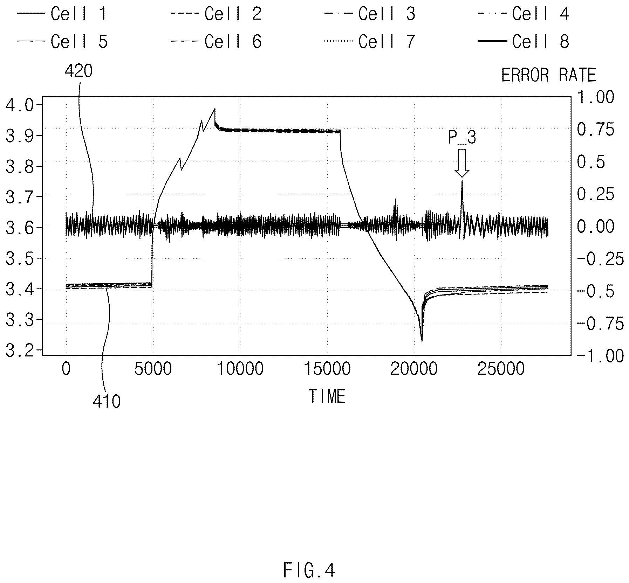

FIG. 4 shows an example of an error rate deviation of battery cells.

Referring to FIG. 4, a graph 410 regarding a charging/discharging voltage for each battery cell and a graph 420 regarding an error rate deviation of each battery cell are shown. While 8 battery cells are illustrated in FIG. 4, the number of battery cells is not limited thereto.

As the voltage of each battery cell included in the battery pack 1 changes according to the same charging/-discharging pattern, the controller 120 may detect a specific cell having a large error rate deviation from the graph 420 regarding the error rate deviation during this process. For example, the battery diagnosis apparatus 100 may detect a point P_3 at which the absolute value of the error rate exceeds the second value. In this case, the second value may be set between, for example, 0.24 and 0.28.

The controller 120 may mask the error rate with 0 in a period in which the change rate of the current of the battery cell is greater than the threshold degree, such that as the error rate of every cell is masked with 0 in that period, the error rate deviation is 0.

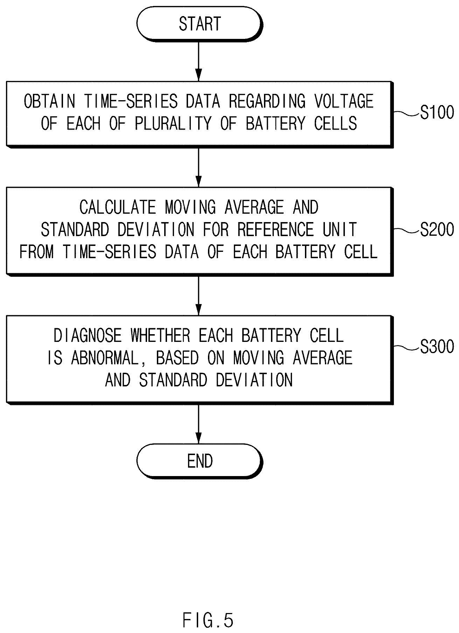

FIG. 5 is a flowchart of a battery diagnosis method according to an embodiment disclosed herein. According to an embodiment, operations shown in FIG. 5 may be performed by the battery management apparatus 100 of FIG. 2.

Referring to FIG. 5, the battery diagnosis method may include operation S100 of obtaining time-series data regarding a voltage of each of a plurality of battery cells, operation S200 of calculating a moving average and a standard deviation for a reference unit from the time-series data of each battery cell, and operation S300 of diagnosing whether each battery cell is abnormal, based on the moving average and the standard deviation.

In operation S100, the information obtaining unit 110 may obtain time-series data regarding a voltage of each of the plurality of battery cells.

In operation S200, The controller 120 may calculate the moving average and the standard deviation for the reference unit from the time-series data of each battery cell.

In operation S300, the controller 120 may diagnose whether each battery cell is abnormal, based on the moving average and the standard deviation. For example, the controller 120 may determine the cell as defective when the moving average and/or standard deviation is greater than the threshold value. In another example, the controller 120 may calculate a parameter (e.g., an error rate) for cell diagnosis from the moving average and the standard deviation and diagnose whether the cell is abnormal, based on the calculated parameter.

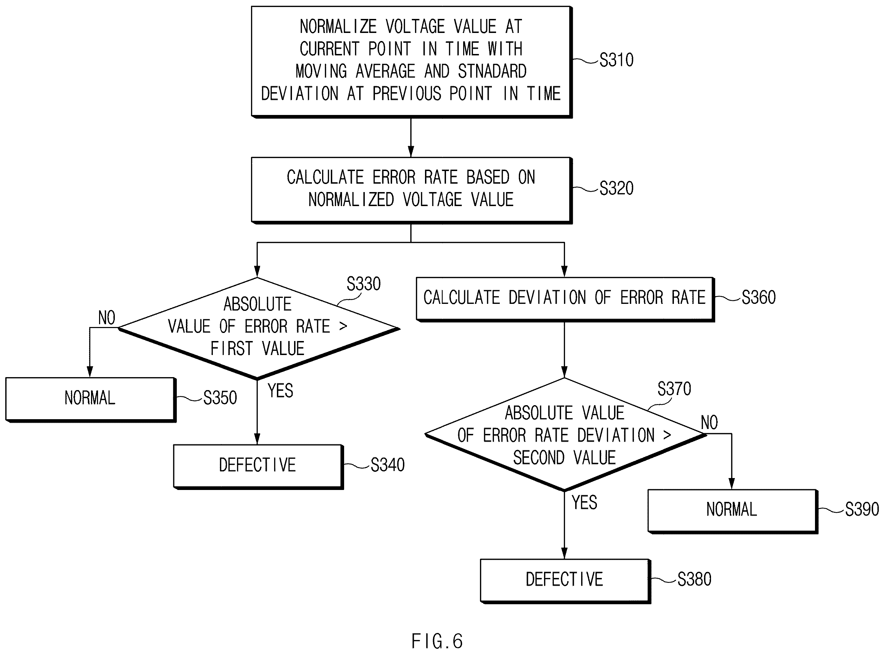

FIG. 6 is a flowchart illustrating in detail a battery diagnosis process according to an embodiment disclosed herein.

Referring to FIG. 6, in operation S310, the controller 120 may normalize a voltage value at a current point in time for each battery cell with a moving average and a standard deviation at a previous point in time. For example, when the current point in time is t, the controller 120 may normalize the voltage $v_t$ of the battery cell with the moving average $mean_{t-1}$ and the standard deviation $std_{t-1}$ at the point (t-1) in time.

In operation S320, the controller 120 may calculate the error rate based on the normalized voltage value for each battery cell. For example, the controller 120 may calculate the error rate by applying the error function to the normalized voltage value.

In operation S330, the controller 120 may determine whether the absolute value of the error rate for each battery cell exceeds the first value.

When the absolute value of the error rate exceeds the first value in operation S330 (Yes), the controller 120 may determine that the corresponding battery cell is defective, in operation S340. When the absolute value of the error rate is less than or equal to the first value in operation S330 (No), the controller 120 may determine that the corresponding battery cell is normal, in operation S350.

In operation S360, the controller 120 may calculate an error rate deviation of each battery cell.

In operation S370, the controller 120 may determine whether the absolute value of the error rate deviation for each battery cell exceeds the second value.

When the absolute value of the error rate deviation exceeds the second value in operation S370 (Yes), the controller 120 may determine that the corresponding battery cell is defective, in operation S380. When the absolute value of the error rate is less than or equal to the first value in operation S370 (No), the controller 120 may determine that the corresponding battery cell is normal, in operation S390.

The controller 120 may selectively, simultaneously, or sequentially perform operations S330 and S360.

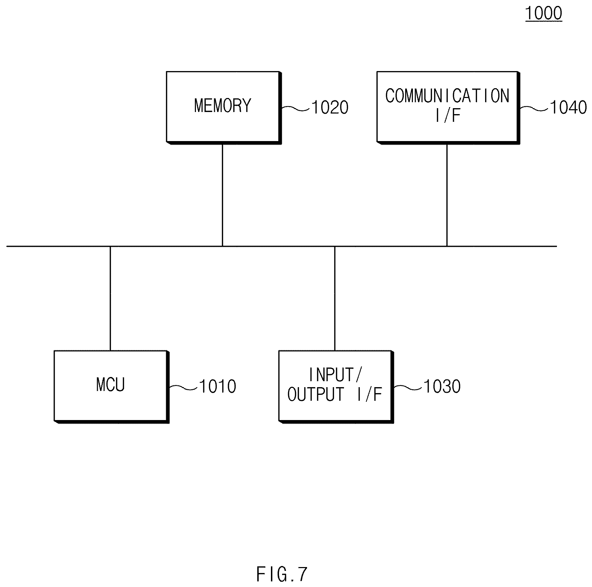

FIG. 7 is a block diagram showing a hardware configuration of a computing system for performing an operating method of a battery management apparatus, according to an embodiment disclosed herein.

Referring to FIG. 7, a computing system 1000 according to an embodiment disclosed herein may include an MCU 1010, a memory 1020, an input/output I/F 1030, and a communication I/F 1040.

The MCU 1010 may be a processor that executes various programs (e.g., a battery cell SOC/OCV collection program, a battery cell parameter calculation program, an SOC-OCV group generation program, a battery cell diagnosis program, etc.) stored in the memory 1020, processes various information including SOC, OCV, parameter, etc., of the battery cell through these programs, and executes the above-described functions of the controller included in the battery management apparatus shown in FIG. 2.

The memory 1020 may store various programs such as a battery cell SOC/OCV collection program, a battery cell parameter calculation program, an SOC-OCV group generation program, a battery cell diagnosis program, etc. Moreover, the memory 1020 may store various information such as SOC, OCV, parameter, etc., of the battery cell.

The memory 1020 may be provided in plural, depending on a need. The memory 1020 may be volatile memory or non-volatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., to the MCU 1010.

The communication I/F 1040, which is a component capable of transmitting and receiving various data to and from a server, may be various devices capable of supporting wired or wireless communication. For example, the battery management apparatus may transmit and receive various information including SOC, OCV, parameter, etc., of the battery cell from an external server separately provided through the communication I/F 1040.

As such, a computer program according to an embodiment disclosed herein may be recorded in the memory 1020 and processed by the MCU 1010, thus being implemented as a module that performs functions shown in FIG. 2.

Even though all components constituting an embodiment disclosed herein have been described above as being combined into one or operating in combination, the embodiments disclosed herein are not necessarily limited to the embodiments. That is, within the object scope of the embodiments disclosed herein, all the components may operate by

**EP 4 697 042 A1**

being selectively combined into one or more.

Moreover, terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in the present document.

The above description is merely illustrative of the technical idea of the present disclosure, and various modifications and variations will be possible without departing from the essential characteristics of embodiments of the present disclosure by those of ordinary skill in the art to which the embodiments disclosed herein pertains. Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present document.

## Claims

1. A battery diagnosis apparatus comprising:

   an information obtaining unit configured to obtain time-series data regarding a voltage of each of a plurality of battery cells; and
   a controller configured to calculate a moving average and a standard deviation for a reference unit from the time-series data of each battery cell, and
   diagnose whether each battery cell is abnormal, based on the moving average and the standard deviation.

2. The battery diagnosis apparatus of claim 1, wherein the controller is further configured to:

   normalize a voltage value at a current point in time for each battery cell with a moving average and a standard deviation at a previous point in time; and
   calculate an error rate based on the voltage value normalized for each battery cell.

3. The battery diagnosis apparatus of claim 2, wherein the controller is further configured to calculate the error rate by applying an error function (erf) to the normalized voltage value.

4. The battery diagnosis apparatus of claim 2, wherein the controller is further configured to determine a battery cell having the error rate, an absolute value of which exceeds a first value, as defective.

5. The battery diagnosis apparatus of claim 4, wherein the first value is set to 0.65.

6. The battery diagnosis apparatus of claim 2, wherein the controller is further configured to mask the error rate with 0 for a period of the time-series data in which a change rate of current is greater than a threshold degree.

7. The battery diagnosis apparatus of claim 2, wherein the controller is further configured to:

   calculate a deviation of the error rate of each battery cell; and
   determine a battery cell having the deviation, an absolute value of which exceeds a second value, as defective.

8. The battery diagnosis apparatus of claim 7, wherein the second value is set to 0.25.

9. A battery diagnosis method comprising:

   obtaining time-series data regarding a voltage of each of a plurality of battery cells;
   calculating a moving average and a standard deviation for a reference unit from the time-series data of each battery cell; and
   diagnosing whether each battery cell is abnormal, based on the moving average and the standard deviation.

**10.** The battery diagnosis method of claim 9, wherein the diagnosing of whether each battery cell is abnormal comprises:

normalizing a voltage value at a current point in time for each battery cell with a moving average and a standard deviation at a previous point in time; and
calculating an error rate based on the voltage value normalized for each battery cell.

**11.** The battery diagnosis method of claim 10, wherein the diagnosing of whether each battery cell is abnormal further comprises determining a battery cell having the error rate, an absolute value of which exceeds a first value, as defective.

**12.** The battery diagnosis method of claim 10, wherein the calculating of the error rate comprises calculating the error rate by applying an error function (erf) to the normalized voltage value.

**13.** The battery diagnosis method of claim 10, wherein the calculating of the error rate comprises masking the error rate with 0 for a period of the time-series data in which a change rate of current is greater than a threshold degree.

**14.** The battery diagnosis method of claim 10, wherein the diagnosing of whether each battery cell is abnormal further comprises:

calculating a deviation of the error rate of each battery cell; and
determining a battery cell having the deviation, an absolute value of which exceeds a second value, as defective.

PLURALITY OF
BATTERY CELLS
10

BMS
20

HIGHER-LEVEL
CONTROLLER
2

FIG.1

100

INFORMATION
OBTAINING UNIT
110

CONTROLLER
120

FIG.2

FIG.3A

FIG.3B

FIG.3C

FIG.3D

FIG.4

START

OBTAIN TIME-SERIES DATA REGARDING VOLTAGE
OF EACH OF PLURALITY OF BATTERY CELLS — S100

CALCULATE MOVING AVERAGE AND
STANDARD DEVIATION FOR REFERENCE UNIT — S200
FROM TIME-SERIES DATA OF EACH BATTERY CELL

DIAGNOSE WHETHER EACH BATTERY CELL
IS ABNORMAL, BASED ON MOVING AVERAGE — S300
AND STANDARD DEVIATION

END

FIG.5

FIG.6

EP 4 697 042 A1

1000

```
┌─────────────┐              ┌──────────────────┐
│   MEMORY    │ ～1020        │ COMMUNICATION    │ ～1040
│             │              │     I/F          │
└──────┬──────┘              └────────┬─────────┘
       │                              │
───────┼──────────────────────────────┼───────────────
       │                              │
┌──────┴──────┐              ┌────────┴─────────┐
│     MCU     │ ～1010        │   INPUT/         │ ～1030
│             │              │  OUTPUT  I/F     │
└─────────────┘              └──────────────────┘
```

FIG.7

## INTERNATIONAL SEARCH REPORT

| International application No. |
| --- |
| **PCT/KR2023/017024** |

**A. CLASSIFICATION OF SUBJECT MATTER**

**G01R 31/392**(2019.01)i; **G01R 31/396**(2019.01)i; **G01R 31/367**(2019.01)i; **G01R 19/00**(2006.01)i; **G01R 19/165**(2006.01)i; **G01R 19/12**(2006.01)i

According to International Patent Classification (IPC) or to both national classification and IPC

**B. FIELDS SEARCHED**

Minimum documentation searched (classification system followed by classification symbols)

G01R 31/392(2019.01); G01R 19/00(2006.01); G01R 31/36(2006.01); G01R 31/367(2019.01); G01R 31/3842(2019.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 전지(battery), 셀(cell), 시계열(time series), 이동평균(moving average), 표준편차(standard deviation), 전압(voltage)

**C. DOCUMENTS CONSIDERED TO BE RELEVANT**

| Category* | Citation of document, with indication, where appropriate, of the relevant passages | Relevant to claim No. |
| --- | --- | --- |
| X | KR 10-2022-0074797 A (LG ENERGY SOLUTION, LTD.) 03 June 2022 (2022-06-03)<br>See paragraphs [0103]-[0166] and claims 1-5. | 1-14 |
| A | KR 10-2023-0057894 A (LG ENERGY SOLUTION, LTD.) 02 May 2023 (2023-05-02)<br>See entire document. | 1-14 |
| A | KR 10-1637683 B1 (HYUNDAI MOTOR COMPANY) 07 July 2016 (2016-07-07)<br>See claims 3-6. | 1-14 |
| A | KR 10-1799564 B1 (LG CHEM, LTD.) 20 December 2017 (2017-12-20)<br>See claims 1-3. | 1-14 |
| A | US 2022-0196754 A1 (SAMSUNG SDI CO., LTD.) 23 June 2022 (2022-06-23)<br>See entire document. | 1-14 |

☐ Further documents are listed in the continuation of Box C.    ☑ See patent family annex.

| | |
| --- | --- |
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **19 February 2024** | **19 February 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2023/017024**

| Patent document cited in search report | | | Publication date (day/month/year) | Patent family member(s) | | | Publication date (day/month/year) |
|---|---|---|---|---|---|---|---|
| KR | 10-2022-0074797 | A | 03 June 2022 | CN | 115461634 | A | 09 December 2022 |
| | | | | EP | 4152021 | A1 | 22 March 2023 |
| | | | | EP | 4152021 | A4 | 03 January 2024 |
| | | | | JP | 2023-519949 | A | 15 May 2023 |
| | | | | US | 11768251 | B2 | 26 September 2023 |
| | | | | US | 2023-0152388 | A1 | 18 May 2023 |
| | | | | US | 2023-0243895 | A1 | 03 August 2023 |
| | | | | WO | 2022-114871 | A1 | 02 June 2022 |
| KR | 10-2023-0057894 | A | 02 May 2023 | CN | 116829966 | A | 29 September 2023 |
| | | | | JP | 2024-500893 | A | 10 January 2024 |
| | | | | WO | 2023-068899 | A1 | 27 April 2023 |
| KR | 10-1637683 | B1 | 07 July 2016 | DE | 102014225645 | B4 | 28 November 2019 |
| | | | | KR | 10-2016-0036422 | A | 04 April 2016 |
| | | | | US | 10797330 | B2 | 06 October 2020 |
| | | | | US | 2016-0091570 | A1 | 31 March 2016 |
| KR | 10-1799564 | B1 | 20 December 2017 | KR | 10-2016-0109640 | A | 21 September 2016 |
| US | 2022-0196754 | A1 | 23 June 2022 | CN | 113785209 | A | 10 December 2021 |
| | | | | EP | 3988952 | A1 | 27 April 2022 |
| | | | | EP | 3988952 | A4 | 19 July 2023 |
| | | | | KR | 10-2021-0000206 | A | 04 January 2021 |
| | | | | WO | 2020-262789 | A1 | 30 December 2020 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230063907